Europäisches Patentamt

European Patent Office

Office européen des brevets

(19)

(11) **EP 1 443 340 A2**

(12) **EUROPÄISCHE PATENTANMELDUNG**

(43) Veröffentlichungstag:
04.08.2004 **Patentblatt 2004/32**

(51) Int Cl.⁷: $G01R\ 31/36$

(21) Anmeldenummer: **04001640.4**

(22) Anmeldetag: **27.01.2004**

(84) Benannte Vertragsstaaten:
**AT BE BG CH CY CZ DE DK EE ES FI FR GB GR
HU IE IT LI LU MC NL PT RO SE SI SK TR**
Benannte Erstreckungsstaaten:
**AL LT LV MK**

(30) Priorität: **30.01.2003 DE 10303505**

(71) Anmelder: **ROBERT BOSCH GMBH
70442 Stuttgart (DE)**

(72) Erfinder:
• **Knapp, Marc
71729 Erdmannshausen (DE)**
• **Beck, Marcus
71711 Stienheim (DE)**

(54) **Verfahren zur Erkennung einer defekten Kraftfahrzeug-Batterie**

(57) Die Erfindung betrifft ein Verfahren sowie eine Vorrichtung zur Erkennung einer defekten Batterie oder eines batterielosen Zustands in einem elektrischen Netz, insbesondere eine Kfz-Bordnetz (6), das von einer Batterie (13) und einem Generator (1) gespeist wird. Ein Batteriedefekt bzw. ein batterieloser Zustand kann besonders einfach erkannt, wenn eine Diagnoseeinheit (4) vorgesehen ist, die die Spannungswelligkeit der Netzspannung $U_{Batt}$ ermittelt und diese bezüglich eines Schwellenwertes überwacht.

Fig. 1

EP 1 443 340 A2

**Beschreibung**

Die Erfindung betrifft ein Verfahren zur Erkennung einer defekten Batterie oder eines batterielosen Zustands in einem elektrischen Netz, insbesondere einem Kfz-Bordnetz, gemäß dem Oberbegriff des Patentanspruchs 1, sowie eine entsprechende Vorrichtung gemäß dem Oberbegriff des Patentanspruchs 5.

Unter einem batterielosen Zustand wird in dieser Beschreibung ein Zustand verstanden, bei dem die Batterie, z.B. durch Losrütteln des Batteriekabels, nicht mehr mit dem Netz verbunden ist.

In einem Kfz-Bordnetz werden die elektrischen Verbraucher üblicherweise von einer Batterie und - bei laufendem Motor - von einem Generator mit elektrischen Energie versorgt. Durch die zunehmende Verbreitung sicherheitsrelevanter elektrischer Verbraucher, wie z.B. elektrohydraulischer Bremsen (EHB) oder Steuergeräte, wird die Stabilität und insbesondere die Ausfallsicherheit elektrischer Fahrzeug-Bordnetze immer wichtiger.

Um einen Aufall der Fahrzeugbatterie rechtzeitig erkennen zu können, wird der Batteriezustand daher ständig überwacht. Zu diesem Zweck umfassen moderne Bordnetze eine Einrichtung zur Batteriezustandserkennung, die, z.B. aus den Batterie-Betriebsgrößen, nämlich Batteriestrom, Batteriespannung und Batterietemperatur, mit Hilfe eines vorgegebenen mathematischen Batteriemodells, den Ladezustand und/ oder die Leistungsfähigkeit der Batterie abschätzt. Dieses Verfahren ist jedoch relativ kompliziert und aufwändig.

Es ist daher die Aufgabe der vorliegenden Erfindung, ein Diagnoseverfahren bzw. ein Diagnosesystem zu schaffen, das einen batterielosen Zustand oder einen Batteriedefekt in einfacher Weise erkennen kann.

Gelöst wird diese Aufgabe gemäß der Erfindung durch die im Patentanspruch 1 sowie im Patentanspruch 5 angegebenen Merkmale. Weitere Ausgestaltungen der Erfindung sind Gegenstand von Unteransprüchen. Sie ermöglichen durch Erkennen eines Batterieausfalls ein Warnkonzept, das den Fahrer vor dem Eintritt einer sicherheitsrelevanten Situation warnen kann.

Der wesentliche Gedanke der Erfindung besteht darin, die Spannungswelligkeit der Bordnetzspannung zu Erkennung des batterielosen Zustands oder eines Batteriedefekts heranzuziehen und in Abhängigkeit von der Höhe der Spannungswelligkeit entweder auf Normalbetrieb oder einen batterielosen Betrieb bzw. einen Batteriedefekt zu schließen.

In einem elektrischen Gleichspannungsnetz, wie z.B. einem Kfz-Bordnetz, das außer von einer Batterie auch von einem Generator mit elektrischer Energie versorgt wird, ist die Netzspannung (z.B. 14 V Gleichspannung) von einer durch den Generator verursachten Wechselspannung (z.B. 0,3V Wechselanteil) überlagert. Durch die Pufferwirkung der Batterie wird der vom Generator verursachte Wechselanteil gedämpft (z.B. auf 0,1V). Bei defekter Batterie oder im batterielosen Zustand ist dagegen der Wechselspannungsanteil maximal. Es ist somit möglich, durch Überwachung des Wechselspannungsanteils einen Batteriedefekt bzw. einen batterielosen Zustand zu erkennen. Eine Berücksichtigung weiterer Größen ist hierzu nicht erforderlich.

Gemäß der Erfindung wird daher eine Diagnoseeinrichtung vorgeschlagen, die die Spannungswelligkeit der Netzspannung zu verschiedenen Zeitpunkten ermittelt und die vorzugsweise einen Mittelwert der Spannungswelligkeit bildet. Die Amplitude der Spannungswelligkeit bzw. die Größe des Mittelwerts kann im folgenden Schwellenwert überwacht werden. D.h. überschreitet die Spannungswelligkeit bzw. deren Mittelwert einen vorgegebenen Schwellenwert, so wird ein Batteriedefekt bzw. ein batterieloser Zustand erkannt. Diese Information kann an ein übergeordnetes System, das die Fehlfunktion anzeigt, weitergeleitet werden. Durch die Erzeugung eines Mittelwerts kann die Aussagegenauigkeit bezüglich einer Fehlfunktion wesentlich erhöht werden, da einzelne zufällig auftretende Spannungsüberhöhungen oder Spannungseinbrüche im Netz durch die Mittelwertbildung ausgeglichen werden.

Dieser Algorithmus ist besonders einfach und kann kostengünstig in einem Steuergerät implementiert werden, da er auch bei längeren Abtastzeiten der Netzspannung im Bereich von 100ms zuverlässig funktioniert. Neben der Netzspannung sind keine anderweitigen Größen, wie z.B. die Drehzahl des Generators oder der Batteriestrom, zur Erkennung einer defekten Batterie oder eines batterielosen Zustandes notwendig.

Gemäß einer bevorzugten Ausführungsform der Erfindung wird ein gleitender Mittelwert über eine vorgegebene Anzahl von Spannungswelligkeitswerten gebildet. Die Anzahl der Spannungswelligkeitswerte, die zur Mittelwertbildung herangezogen werden, ist vorzugsweise größer als 50 und wird nachfolgend exemplarisch mit 200 angegeben.

Bei der Netzspannung, deren Welligkeit gemessen wird, kann es sich um eine an einem beliebigen Punkt im elektrischen Netz abgegriffene Spannung handeln. Vorzugsweise wird die Spannungswelligkeit der Klemmenspannung der Batterie bestimmt.

Gemäß einer ersten Ausführungsform der Erfindung wird die Netzspannung einer digitalen Diagnoseeinheit zugeführt, die einen A/D-Wandler umfasst und die aus den aufgenommenen Spannungswerten eine mittlere Spannungswelligkeit berechnet. Wahlweise kann der Diagnoseeinheit auch nur der Wechselanteil zugeführt werden, indem zwischen dem Netz und der Diagnoseeinheit eine Einrichtung zur AC-Kopplung vorgesehen wird.

Gemäß einer anderen Ausführungsform der Erfindung wird die Netzspannung, insbesondere die Batteriespannung, einem Tiefpass- oder Bandpassfilter zugeführt, dessen Ausgangssignal digital gewandelt und einer Verarbeitungseinrichtung zugeführt wird, die das resultierende Signal Schwellenwert überwacht. Eine Mittelwertbildung ist dann nicht mehr erforderlich, da durch den Filter die höherfrequenten Anteile (oberhalb der Frequenz des Wechselanteils) unterdrückt werden. Ein vorgeschalteter Bandpassfilter oder AC-Filter hat den Vorteil, dass nur der Wechselanteil von der nachfolgenden digitalen Verarbeitungseinrichtung verarbeitet werden muss und somit Rechenleistung gespart werden kann.

Wird ein Zustand mit Batterieausfall erkannt, beispielsweise ein Schwerwiegender Batteriedefekt, eine extreme Batterieleistungsunfähigkeit oder ein Defekt in der Batterieverkabelung kann dieser Zustand intern auch über eine Kommunikationsschnittstelle anderen Steuergeräten zur weiteren Verwertung für Überwachungs-/Warnkonzepte signalisiert werden.

Spezielle Ausgestaltungen sind mit zwei weiteren Ausführungsformen möglich. Dabei ist die Realisierung des Auswerteverfahrens mit Hilfe eines digitalen Software-Filters in einem Steuergerät von Vorteil. Statt einer gleitenden Mittelwertbildung über N-Klemmen-Spannungs-Messwerte (z.B. mit N = 200) wird ein digitales Software-Tiefpass-Filter erster Ordnung in der Recheneinheit, beispielsweise im μC des Steuergerätes verwendet. Dies führt zum Vorteil eines geringen Speicherplatzbedarfs, da nur wenige Variablen statt N Pufferwerten benötigt werden und zum Vorteil, dass nur eine geringe Rechenleistung erforderlich ist.

Die Erfindung wird nachstehend anhand der beigefügten Zeichnungen beispielhaft näher erläutert. Es zeigen:

Fig. 1 ein elektrisches Bordnetz mit einer Diagnoseeinheit zur Überwachung der Spannungswelligkeit;

Fig. 2 ein elektrisches Bordnetz mit einer Diagnoseeinheit gemäß einer anderen Ausführungsform der Erfindung; und

Fig. 3 ein Flussdiagramm zur Darstellung der wesentlichen Verfahrensschritte bei der Erkennung eines Batteriedefekts bzw. eines batterielosen Zustandes in einem Bordnetz;

Fig. 4 und Fig. 5 zwei weitere Ausführungsbeispiele und

Fig. 6 verschiedene Frequenzgänge eines Mittelwertbildners.

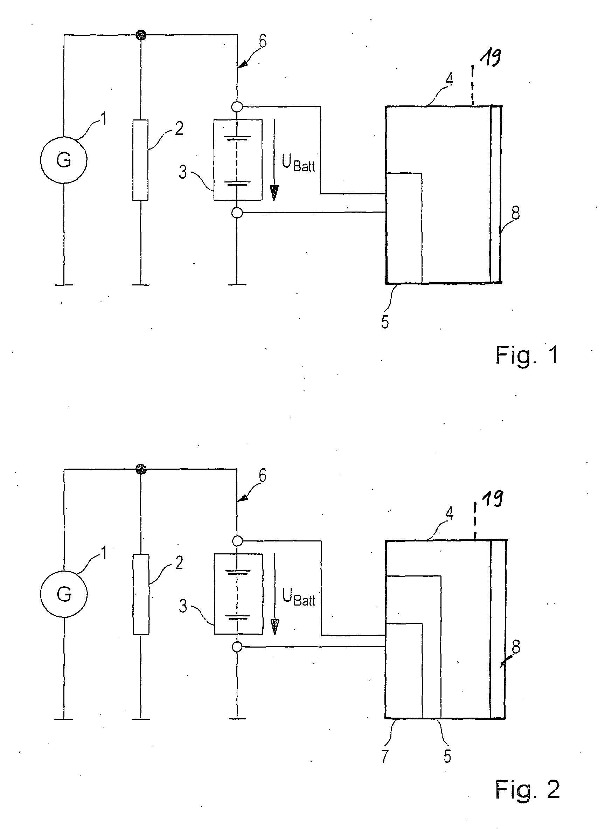

Figur 1 zeigt eine stark vereinfachte schematische Darstellung eines Kfz-Bordnetzes 6, das von einem Generator 1 und einer Batterie 3 mit elektrischer Energie versorgt wird. Die im elektrischen Bordnetz angeschlossenen Verbraucher, wie z.B. Heizung, Lüftung, Licht etc., sind hier vereinfacht als ein einziger Verbraucher 2 dargestellt. Zur Erkennung einer defekten Batterie oder eines batterielosen Zustandes ist eine Diagnoseeinheit 4 vorgesehen, die an der Batterie 3 angeschlossen ist. Die Diagnoseeinheit 4 kann wahlweise auch an einem beliebigen anderen Punkt im Bordnetz angeschlossen sein, um dort eine Netzspannung abzugreifen.

Wegen der Versorgung des Bordnetzes 6 durch den Generator 1 hat die Netzspannung immer einen geringen Wechselanteil, die sogenannte Spannungswelligkeit (z. B. 0,1V). Als Spannungswelligkeit wird hier insbesondere die Schwankungsbreite des Wechselanteils der Netzspannung zwischen positiver und negativer Amplitude verstanden. Solange die Batterie 3 intakt ist und mit dem Bordnetz 6 in Verbindung steht, wird die Spannungswelligkeit auf einen relativ kleinen Wert gedämpft (z.B. 0,1V). Bei einem Batteriedefekt bzw. einem batterielosen Zustand steigt die Spannungswelligkeit dagegen wegen der fehlenden Pufferwirkung der Batterie 3 wesentlich an (z.B. auf 0,3V). Somit kann in einfacher Weise, ohne weitere Größen, wie z.B. die Generatordrehzahl, berücksichtigen zu müssen, ein Batteriedefekt bzw. ein batterieloser Zustand erkannt werden, wenn die Spannungswelligkeit über einen vorgegebenen Schwellenwert steigt.

Im vorliegenden Ausführungsbeispiel umfasst die Diagnoseeinheit 4 einen A/D-Wandler 5 sowie eine digitale Verarbeitungseinrichtung 8 oder ist Bestandteil einer Verarbeitungseinrichtung 8, die derart eingerichtet ist, dass sie einen Spannungswelligkeits-Mittelwert der Netzspannung ermittelt und den Mittelwert Schwellenwert überwacht. D.h., überschreitet der Mittelwert einen vorgegebenen Schwellenwert, so wird ein Batteriedefekt bzw. ein batterieloser Zustand erkannt und ein entsprechendes Signal an ein übergeordnetes System ausgegeben. Dem Fahrer kann somit z.B. eine optische oder akustische Information gegeben werden, dass ein Defekt vorliegt und eine Werkstatt aufzusuchen ist. In einer Erweiterung kann eine Kommunikationsschnittstelle 19 vorgesehen sein, über die Informationen mit weiteren Verarbeitungseinrichtung bzw. mit Steuergeräten ausgetauscht werden.

In Fig. 1 wird die Gleichspannung von der Diagnoseeinheit 4 abgetastet. Wahlweise kann durch eine AC-Kopplung oder einen Bandpassfilter auch nur der Wechselanteil abgetastet werden.

Figur 2 zeigt eine schematische Darstellung eines Kfz-Bordnetzes 6 mit einer Diagnoseeinheit 4 gemäß einer anderen Ausführungsform der Erfindung. Die Diagnoseeinheit 4 umfasst in diesem Fall einen Filter 7, wie z.B. einen Bandpassfilter, dem die Batteriespannung $U_{Batt}$ zugeführt wird und der nur den Wechselanteil der Netzspannung durchlässt. Somit können in der nachgeschalteten Verarbeitungseinrichtung 8 Rechenund Speicherressourcen eingespart werden. Eine Mittelwertbildung ist in diesem Fall nicht mehr oder nur noch in stark reduzierter Weise erforderlich. Über eine Kommunikationsschnittstelle 19 können Informationen weitergeleitet werden.

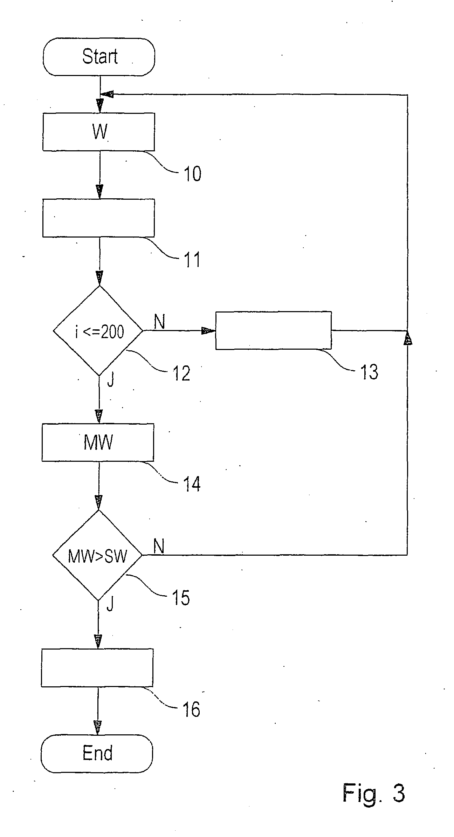

Figur 3 zeigt eine Darstellung der wesentlichen Verfahrensschritte bei der Ermittlung und Überwachung der Spannungswelligkeit in Form eines Flußdiagramms. Dabei wird in Schritt 10 zunächst die Spannungswelligkeit W aus dem Betrag der Differenz von zwei Abtastwerten der Netzspannung $U_{Batt}$ berechnet, wobei gilt W = Abs($U_{Batt\_neu}$ - $U_{Batt\_alt}$). Dieser Wert wird in Schritt 11 in einem Puffer gespeichert. In Schritt 12 wird verglichen, ob bereits 200 Werte $W_i$ gespeichert sind. Bei weniger als 200 Werten wird ein Mittelwert MW der Spannungswelligkeit aus den bisher gespeicherten Spannungswelligkeitswerten W berechnet (Schritt 14). Der berechnete Mittelwert MW wird in Schritt 15 mit einem vorgegebenen Schwellenwert SW verglichen. Überschreitet der Mittelwert MW den Schwellenwert SW, so wird in Schritt 16 ein Fehlersignal ausgegeben, das einen Batteriedefekt bzw. einen batterielosen Zustand signalisiert. Ist der Mittelwert MW dagegen kleiner als der Schwellenwert SW, so wird das Verfahren fortgesetzt, bis die Anzahl i der Spannungswelligkeitswerte W größer als 200 ist. Wird dagegen in Schritt 12 die Anzahl von 200 Welligkeitswerten W überschritten, so werden in Schritt 13 sämtliche Variablen zurückgesetzt und ein neuer Rechenzyklus begonnen. Es wird also ein gleitender Mittelwert aus 200 Welligkeitswerten W gebildet.

Statt einer gleitenden Mittelwertbildung über N Klemmen-Spannungs-Messwerte soll nun die Verwendung eines digitalen Software-Tiefpass-Filters beschrieben werden.

Der Mittelwertbildner über N Messwerte ist ein Filter N-ter Ordnung mit der Übertragungsfunktion

$$F_{MW\_N}(Z) = \frac{1}{N}(1 + z^{-1} + z^{-2} + ... + z^{-N}).$$

Die Einhüllende des Frequenzganges von $F_{MW-N}(z)$ hat bei einer Abtastzeit von exemplarisch $T_s$ = 10ms und einer Anzahl von exemplarisch N=200 Pufferwerten eine -3 dB-Grenzfrequenz von

$$f_{g,MW200} = 0{,}22 \text{ Hz},$$

und eine Steilheit von -10 dB/Dekade.

Das Verhalten läßt sich gut mit einem Tiefpass 1. Ordnung und einer Grenzfrequenz

$$f_{g,TP} = 0{,}17 \text{ Hz} \Rightarrow \omega_{g,TP} = 0{,}34\ \pi \text{ rad/s}$$

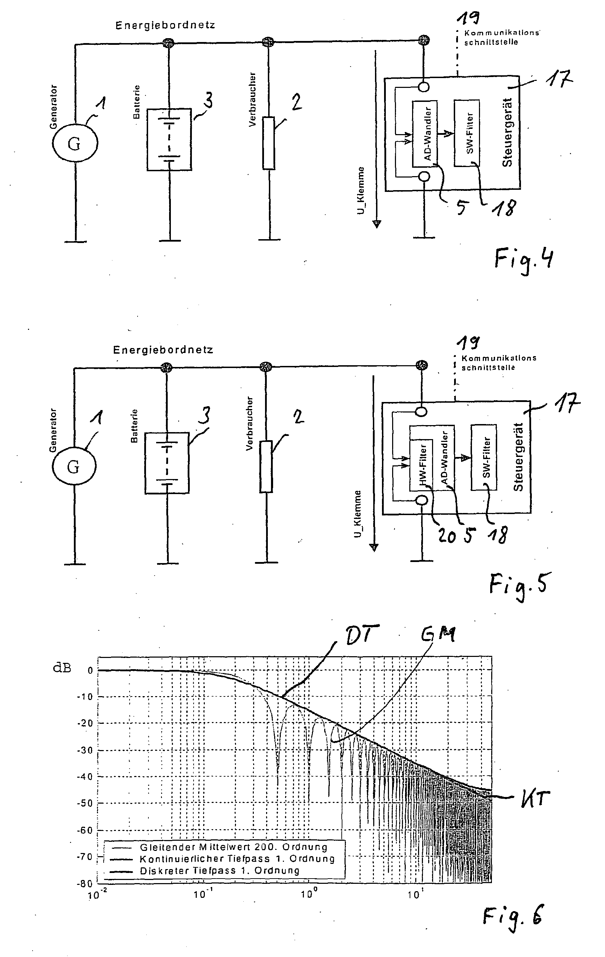

approximieren. Figur 6 zeigt ein Beispiel für verschiedene Frequenzgänge. Diese Werte gelten als exemplarisch vorteilhafte Werte. Aufgetragen ist die Dämpfung in dB über der Frequenz. Die einzelnen Frequenzgänge werden dabei für einen gleitenden Mittelwert 200. Ordnung GM, einen kontinuierlichen Tiefpass 1. Ordnung KT und einen diskreten Tiefpass DT erhalten.

Ein Tiefpass erster Ordnung ist als besonders vorteilhaft anzusehen, eine Verwendung eines Filters höherer Ordnung ist jedoch auch möglich. Ebenso kann es unter bestimmten Voraussetzungen günstig sein, ein Filter zu verwenden, welches einen oder mehrere kritische Frequenzbereiche herausfiltert.

Mögliche Ausführungsformen der Erfindung sollen nun angegeben werden.

Figur 4 zeigt den prinzipiellen Aufbau eine weiteren Ausführungsform. Das Steuergerät 17, das beispielsweise der Verarbeitungseinrichtung 8 entspricht, in dem die Funktion umgesetzt ist, ist an einem beliebigen Punkt des Energiebordnetzes angeschlossen und tastet in vorteilhafter Weise seine Klemmenspannung ab. Alternativ ist die Abtastung einer beliebigen anderen Spannung im Bordnetzverbund möglich.

Die Abtastung erfolgt durch einen A/D-Wandler 5, der die abgetasteten Werte an eine Recheneinheit, beispielsweise den in der Zeichnung nicht dargestellten μC des Steuergerätes 17 weitergibt, wo sie durch einen Softwarefilter 18 der beschriebenen Art, also einen Tiefpass erster Ordnung verarbeitet werden. Danach erfolgt die Schwellwert-Auswertung wie vorstehend im Zusammenhang mit den Figuren 1 bis 3 beschrieben. Über eine Kommunikationsschnittstelle 19 kann eine Verbindung zu weiteren Steuergeräten hergestellt werden.

Figur 5 zeigt eine Variante: Alternativ kann die Filter-Funktionalität auch durch ein elektronisches Hardware-Tiefpass-Filter erster Ordnung 20 umgesetzt werden, das vor dem A/D-Wandler 5 verbaut wird. Dem A/D-Wandler schließt sich noch das Software-Filter 19 an. Die weitere Auswertung erfolgt analog zum Beispiel nach Figur 4. Diese Variante deckt sich im übrigen größtenteils mit den im Zusammenhang mit den Figuren 1, 2 und 3 beschriebenen Ausführungsformen.

Bezugszeichenliste

| | |
|---|---|
| 1 | Generator |
| 2 | Verbraucher |
| 3 | Batterie |
| 4 | Diagnoseeinheit |
| 5 | A/D-Wandler |
| 6 | Bordnetz |
| 7 | Filter |
| 8 | Verarbeitungseinrichtung |
| 10-16 | Verfahrensschritte |
| $U_{Batt}$ | Batteriespannung |
| GM | Frequenzgang für gleitenden Mittelwert'200. Ordn. |
| KT | Frequenzgang für kontinuierlichen Tiefpass 1. Ordn. |
| DT | Frequenzgang für diskreten Tiefpass |
| 17 | Steuergerät |
| 18 | Softwarefilter |
| 19 | Kommunikationsschnittstelle |

20      Hardware-Filter.


**Patentansprüche**

1.  Verfahren zur Erkennung einer defekten Batterie (3) oder eines batterielosen Zustands in einem elektrischen Netz (6), insbesondere einem Kfz-Bordnetz, das von einer Batterie (3) und einem Generator (1) gespeist wird, **gekennzeichnet durch** folgende Schritte:

    -   Ermitteln der Spannungswelligkeit einer Netzspannung ($U_{Batt}$) zu verschiedenen Zeiten, und
    -   Schwellenwert überwachen der Spannungswelligkeit.

2.  Verfahren nach Anspruch 1, **dadurch gekennzeichnet, dass** ein Mittelwert der Spannungswelligkeit gebildet wird.

3.  Verfahren nach Anspruch 1 oder 2, **dadurch gekennzeichnet, dass** die Netzspannung einer Diagnoseeinheit (4) mit einem A/D-Wandler (5) zugeführt wird, die einen Spannungswelligkeits-Mittelwert berechnet.

4.  Verfahren nach Anspruch 1 oder 2, **dadurch gekennzeichnet, dass** die Netzspannung ($U_{Batt}$) einer Diagnoseeinheit (4) zugeführt wird, die einen Filter (7), einen A/D-Wandler (5) und eine Verarbeitungseinrichtung (8) zur Bestimmung der Spannungswelligkeit umfasst.

5.  Vorrichtung zur Erkennung einer defekten Batterie oder eines batterielosen Zustands in einem elektrischen Netz (6), insbesondere einem Kfz-Bordnetz, das von einer Batterie (3) und einem Generator (1) gespeist wird, **gekennzeichnet durch** eine Diagnoseeinheit (4), die derart gestaltet ist, dass sie die Spannungswelligkeit einer Netzspannung ($U_{Batt}$) zu verschiedenen Zeiten ermittelt, die Spannungswelligkeit Schwellenwert überwacht und bei Überschreiten des Schwellenwerts ein Fehlersignal ausgibt.

6.  Vorrichtung nach Anspruch 5, **dadurch gekennzeichnet, dass** die Diagnoseeinheit (4) einen Mittelwert der Spannungswelligkeit bildet.

7.  Vorrichtung nach Anspruch 5 oder 6, **dadurch gekennzeichnet, dass** die Diagnoseeinheit (4) einen A/D-Wandler (5) umfasst, dem die Netzspannung ($U_{Batt}$) zugeführt wird.

8.  Vorrichtung nach Anspruch 5 oder 6, **dadurch gekennzeichnet, dass** die Diagnoseeinheit (4) wenigstens einen Filter umfasst, dem die Netzspannung ($U_{Batt}$) zugeführt wird.

9.  Vorrichtung nach Anspruch 8, **dadurch gekennzeichnet, dass** als Filter ein Hardware- oder ein Softwarefilter oder eine Kombination aus beiden Filterarten eingesetzt wird.

10. Vorrichtung nach einem der vorhergehenden Ansprüche 4 bis 9, **dadurch gekennzeichnet, dass** die Diagnoseeinheit Bestandteil eines Steuergerätes ist.

11. Vorrichtung nach Anspruch 10, **dadurch gekennzeichnet, dass** eine Kommunikationsschnittstelle zwischen dem Steuergerät und wenigstens einem weiteren Steuergerät vorhanden ist, über die Informationen austauschbar sind.

Fig. 1

Fig. 2

```
           ┌─────────────┐
           │    Start    │
           └─────────────┘
                  │
                  ▼◄────────────────────────────────┐
           ┌─────────────┐                          │
           │      W      │                          │
           └─────────────┘──── 10                   │
                  │                                  │
                  ▼                                  │
           ┌─────────────┐                          │
           │             │                          │
           └─────────────┘──── 11                   │
                  │                                  │
                  ▼                                  │
               ╱─────╲          N    ┌───────────┐  │
              ╱ i<=200 ╲──────────────│           │──┤
              ╲        ╱              └───────────┘  │
               ╲─────╱──── 12              │ ── 13   │
                  │J                                 │
                  ▼                                  │
           ┌─────────────┐                          │
           │     MW      │                          │
           └─────────────┘──── 14                   │
                  │                                  │
                  ▼                                  │
               ╱─────╲          N                   │
              ╱ MW>SW ╲──────────────────────────────┘
              ╲       ╱
               ╲─────╱──── 15
                  │J
                  ▼
           ┌─────────────┐
           │             │
           └─────────────┘──── 16
                  │
                  ▼
           ┌─────────────┐
           │     End     │
           └─────────────┘
```

Fig. 3

7

Fig. 4

Fig. 5

Fig. 6